(19) Europäisches Patentamt
European Patent Office
Office européen des brevets

(11) **EP 1 349 201 A1**

(12) **EUROPEAN PATENT APPLICATION**
published in accordance with Art. 158(3) EPC

(43) Date of publication:
**01.10.2003 Bulletin 2003/40**

(51) Int Cl.7: **H01L 21/027**, G03F 7/20, G01B 11/24, G01M 11/00, G02B 7/02, G02B 13/24

(21) Application number: **01999962.2**

(22) Date of filing: **22.11.2001**

(86) International application number:
**PCT/JP01/10257**

(87) International publication number:
**WO 02/047130 (13.06.2002 Gazette 2002/24)**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **06.12.2000 JP 2000370871**

(71) Applicant: **Nikon Corporation**
**Tokyo 100-8331 (JP)**

(72) Inventor: **NAGAYAMA, Tadashi,**
**c/o Nikon Corporation**
**Chiyoda-ku, Tokyo 100-8331 (JP)**

(74) Representative: **HOFFMANN - EITLE**
**Patent- und Rechtsanwälte**
**Arabellastrasse 4**
**81925 München (DE)**

(54) **OBSERVATION DEVICE AND ITS MANUFACTURING METHOD, EXPOSURE DEVICE, AND METHOD FOR MANUFACTURING MICRO DEVICE**

(57) A method for manufacturing an observation apparatus by which the residual aberration including a high-order aberration component of the wavefront aberration can be corrected favorably. A method for manufacturing an observation apparatus for observing an image of the surface (WH) to be inspected formed by way of an image-forming optical system (7, 6, 10, 11, 12(14)). The methods include an aberration measuring step of measuring the residual aberration remaining in the image-forming optical system, and an installing step of installing a correction plate (17), at least one of the surfaces of which is processed to be aspheric form, at a predetermined position in the optical path of the image-forming optical system.

**Fig.1**

## Description

## Technical Field

The present invention relates to an observation apparatus and a method of manufacturing the same, an exposure apparatus, and a method of manufacturing a microdevice. In particular, the present invention relates to a correction (adjustment) of residual aberration in an observation apparatus mounted to an exposure apparatus for manufacturing a microdevice such as semiconductor device, imaging device, liquid crystal display device, and thin-film magnetic head by a lithography process.

## Background Art

In general, when manufacturing a device such as semiconductor device, a plurality of layers of circuit patterns are formed in an overlapping manner on a wafer (or a substrate such as a glass plate) coated with a photosensitive material. Therefore, an exposure apparatus for exposing circuit patterns to the wafer is equipped with an alignment apparatus (observation apparatus) for positioning (aligning) a mask pattern with respect to each exposure area of the wafer which has already been formed with a circuit pattern.

Conventionally known as this kind of alignment apparatus are off-axis and imaging type alignment apparatus as disclosed in Japanese Patent Application Laid-Open No. HEI 4-65603 (and its correspondingU.S. PatentNo. 5,493,403) , Japanese Patent Application Laid-Open No. HEI 4-273246 (and its corresponding U.S. Patent No. 6,141,107), and the like. Detection systems in the alignment apparatus of this imaging type are also known as FIA (Field Image Alignment) system. In the FIA system, an alignment mark (wafer mark) on a wafer is illuminated with light having a wide wavelength band emitted from a light source such as a halogen lamp. Then, by way of an image-forming optical system, an enlarged image of the wafer mark is formed on an imaging device, and thus obtained imaging signal is subjected to image processing, so as to detect the position of the wafer mark.

The FIA system is advantageous in that it uses wide-band illumination as mentioned above, thereby reducing influences of thin-film interference in a photoresist layer on the wafer. However, aberrations slightly remain in the image-forming optical system of the conventional FIA system by way of manufacturing steps of processing, assembling, adjusting, and the like. If aberrations remain in the image-forming optical system, the wafer mark image may lower its contrast on the imaging surface or generate distortions, whereby detection errors will occur in mark positions. Recently, as the line width of circuit patterns has been decreasing, alignment with a higher precision has become necessary.

Among the aberrations remaining in an optical system, those asymmetric about the optical axis such as coma are greatly influential in detecting the wafer mark image. When coma symmetric about the optical axis or a lateral aberration asymmetric about the optical axis in apupil such as eccentric coma occurs on an image surface, the wafer mark image formed on the imaging surface is measured while deviating from that of the ideally formed image. Also, when the form (pitch, duty ratio, stepheight, or the like) of thewafermarkchanges or the wafer mark is defocused, the influence of coma on the wafer mark image varies, whereby the amount of deviation of its measured position varies as well. If aberrations symmetric about the optical axis such as spherical aberration occur, the back focus position will shift every time the wafer mark form changes.

Since the wafer mark form varies from one semiconductor device manufacturing process to another, so-called process offset occurs when alignment (positioning) of the wafer is carried out in an optical system in which ccma remains. Therefore, for correcting the remaining coma such as that mentioned above, the applicant has proposed a technique for correcting coma in an optical system downstream an objective lens in Japanese Patent Application Laid-Open No. HEI 8-195336 (and its corresponding U.S. Patent No.5,680,200). However, the coma correctable in the technique disclosed in Japanese Patent Application Laid-Open No. HEI 8-195336 (and its corresponding U.S. Patent No. 5,680,200) is only lower-order coma, whereas higher-order coma is hard to correct. Thus, in general, lower-order aberration components of wavefront aberration can be corrected by conventional optical adjustment, but it is difficult for higher-order aberration components of wavefront aberration to be corrected (adjusted) by a normal optical adjustment.

## Disclosure of the Invention

In view of the problems mentioned above, it is an object of the present invention to provide an observation apparatus and a method of manufacturing the same, which can favorably correct residual aberrations including higher-order aberration components of wavefront aberration.

It is another object of the present invention to provide an exposure apparatus which can position a mask and a photosensitive substrate with respect to each other, for example, with a high accuracy by using an observation apparatus having favorably corrected its residual aberrations, so as to exhibit high optical performances.

It is a further object of the present invention to provide a microdevice manufacturing method which can make a favorable microdevice upon favorable exposure by using an exposure apparatus equipped with an observation apparatus having high optical performances.

For achieving the above-mentioned objects, a first aspect of the present invention provides an observation apparatus for observing an image of a surface of a specimen formed by way of an image-forming optical system, comprising a correction plate disposed in an optical path of the image-forming optical system;

at least one surface of the correction plate being shaped into a predetermined form for correcting an aberration remaining in the image-forming optical system.

A second aspect of the present invention provides a method of manufacturing the observation apparatus in accordance with the first aspect, the method including:

an aberration measuring step of measuring a residual aberration remaining in the image-forming optical system; and

a correcting step of correcting the residual aberration by rotating each of the first and second correction plates about an optical axis of the image-forming optical system.

A third aspect of the present invention provides a method of manufacturing an observation apparatus for observing an image of a surface of a specimen formed by way of an image-forming optical system, the method including:

an aberration measuring step of measuring a residual aberration remaining in the image-forming optical system; and

an installing step of installing a correction plate at a predetermined position in an optical path of the image-forming optical system so as to correct the residual aberration, the correction plate having at least one surface shaped into an aspheric form.

A fourth aspect of the present invention provides a method of manufacturing an observation apparatus for observing an image of a surface of a specimen formed by way of an image-forming optical system, the method including:

an aberration measuring step of measuring a residual aberration remaining in the image-forming optical system;

a calculating step of calculating, according to a result of measurement obtained by the aberration measuring step, a surface form of a correction plate to be disposed at a predetermined position in an optical path of the image-forming optical system so as to correct the residual aberration;

a processing step of processing at least one surface of the correction plate according to a result of calculation obtained by the calculating step; and

an installing step of installing at the predetermined position in the optical path of the image-forming optical system the correction plate processed by the processing step.

A fifth aspect of the present invention provides a method of manufacturing an observation apparatus for observing an image of a surface of a specimen formed by way of an image-forming optical system, the method including:

an aberration measuring step of measuring a residual aberration remaining in the image-forming optical system; and

a correcting step of correcting the residual aberration by processing at least one of a plurality of optical surfaces constituting the image-forming optical system into an aspheric form.

A sixth aspect of the present invention provides a method of manufacturing an observation apparatus for observing an image of a surface of a specimen formed by way of an image-forming optical system, the method including:

a surface form measuring step of measuring a surface form of an optical surface of each optical member constituting the image-forming optical system;

an optical characteristic measuring step of measuring an optical characteristic distribution of each optical member constituting the image-forming optical system;

an aberration measuring step of measuring a residual aberration remaining in the image-forming optical system by using an interferometer;

a chromatic aberration estimating step of estimating a chromatic aberration occurring in the image-forming optical system according to a result of measurement obtained by the surface form measuring step, a result of measurement obtained by the optical characteristic measuring step, and a result of measurement obtained by the aberration measuring step; and

an adjusting step of adjusting the image-forming optical system so as to correct the chromatic aberration estimated by the chromatic aberration estimating step.

A seventh aspect of the present invention provides a method of manufacturing an observation apparatus for observing an image of a surface of a specimen formed by way of an image-forming optical system, the method including:

a surface form measuring step of measuring surface forms of optical surfaces of numbers of optical members made so as to constitute the image-forming optical system;

an optical characteristic measuring step of measuring an optical characteristic distribution of numbers of optical members made so as to constitute the image-forming optical system;

an aberration estimating step of estimating, according to a result of measurement obtained by the surface form measuring step and a result of measurement obtained by the optical characteristic measuring step, an aberration occurring in an image-forming optical system obtained by combining the optical members; and

an assembling step of assembling an image-forming optical system by combining optical members selected according to a result of estimation obtained by the aberration estimating step.

An eighth aspect of the present invention provides an exposure apparatus for exposing a pattern on a mask onto a photosensitive substrate, the exposure apparatus comprising:

an illumination system for illuminating a mask;

a project ion optical system for forming a pattern image of the mask onto a photosensitive substrate; and

the observation apparatus of the first aspect for observing the mask or the photosensitive substrate as a surface of a specimen.

A ninth aspect of the present invention provides an exposure method for exposing a pattern of a mask to a photosensitive substrate;

wherein the exposure apparatus of the eighth aspect is used for forming the pattern image of the illuminated mask onto a photosensitive substrate.

A tenth aspect of the present invention provides a method of manufacturing a microdevice, the method including an exposure step of exposing a pattern of the mask onto the photosensitive substrate by using the exposure apparatus of the eighth aspect, and a developing step of developing the photosensitive substrate exposed by the exposure step.

An eleventh aspect of the present invention provides an exposure apparatus for exposing a pattern on a mask onto a photosensitive substrate, the exposure apparatus comprising:

an illumination system for illuminating a mask;

a projection optical system for forming a pattern image of the mask onto a photosensitive substrate; and

an observation apparatus for observing the mask or the photosensitive substrate as a surface of a specimen;

wherein the observation apparatus is made by the manufacturing method of the second to seventh aspect.

A twelfth aspect of the present invention provides an exposure method for exposing a pattern of a mask to a photosensitive substrate;

wherein the exposure apparatus of the eleventh aspect is used for forming the pattern image of the illuminated mask onto a photosensitive substrate.

A thirteenth aspect of the present invention provides amethod of manufacturing a microdevice including an exposure step of exposing a pattern of the mask onto the photosensitive substrate by using the exposure apparatus of the eleventh aspect, and a developing step of developing the photosensitive substrate exposed by the exposure step.

**Brief Description of the Drawings**

Fig. 1 is a view schematically showing the configuration of an FIA system as an observation apparatus in accordance with an embodiment of the present invention;

Fig. 2 is a view schematically showing the configuration of an exposure apparatus mounted with the FIA system as the observation apparatus of Fig. 1;

Fig. 3 is a flowchart showing a manufacturing flow in a first method of manufacturing the observation apparatus in accordance with the embodiment;

Fig. 4 is a view schematically showing the configuration of an interferometer apparatus for measuring the wavefront aberration remaining in an assembled image-forming optical system;

Fig. 5 is a view showing a state where a pair of aberration correction plates are installed in a parallel optical path between first and second objective lenses;

Fig. 6 shows the Zernike term 10 aspheric surface by a contour map;

Fig. 7 is a view three-dimensionally showing undulations of the Zernike term 10 aspheric surface with exaggeration;

Fig. 8 shows the Zernike term 14 aspheric surface by a contour map;

Fig. 9 is a view three-dimensionally showing undulations of the Zernike term 14 aspheric surface with exaggeration;

Fig. 10 shows the Zernike term 16 aspheric surface by a contour map;

Fig. 11 is a view three-dimensionally showing undulations of the Zernike term 16 aspheric surface with exaggeration;

Fig. 12 shows the Zernike term 25 aspheric surface by a contour map;

Fig. 13 is a view three-dimensionally showing undulations of the Zernike term 25 aspheric surface with exaggeration;

Fig. 14 is a view schematically showing the configuration of an interferometer apparatus for measuring a wavefront aberration remaining in a first image-forming optical system constituting a part of an image-forming optical system;

Fig. 15 is a flowchart showing a manufacturing flow in a second method of manufacturing the observation apparatus in accordance with the embodiment;

Fig. 16 is a flowchart of a technique for obtaining a semiconductor device as a microdevice; and

Fig. 17 is a flowchart of a technique for obtaining a liquid crystal display device as a microdevice.

## Best Modes for Carrying Out the Invention

An embodiment of the present invention will be explained with reference to the accompanying drawings.

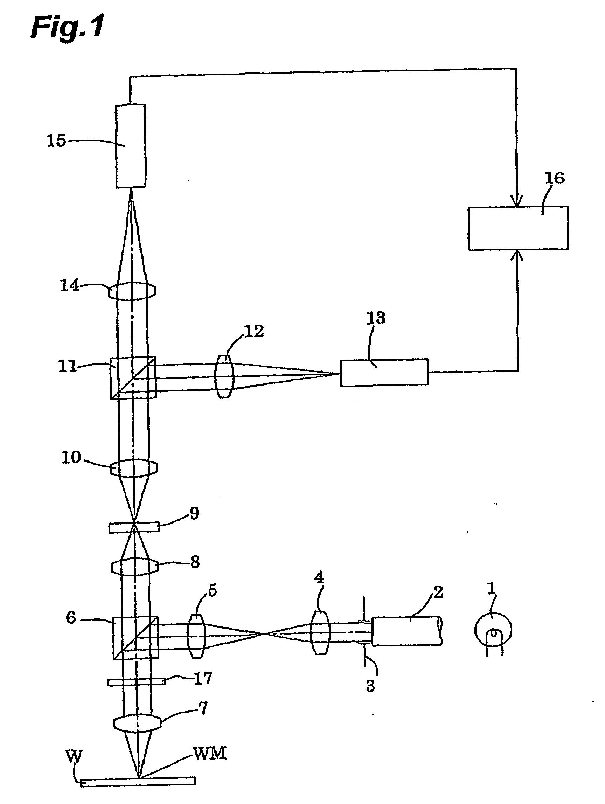

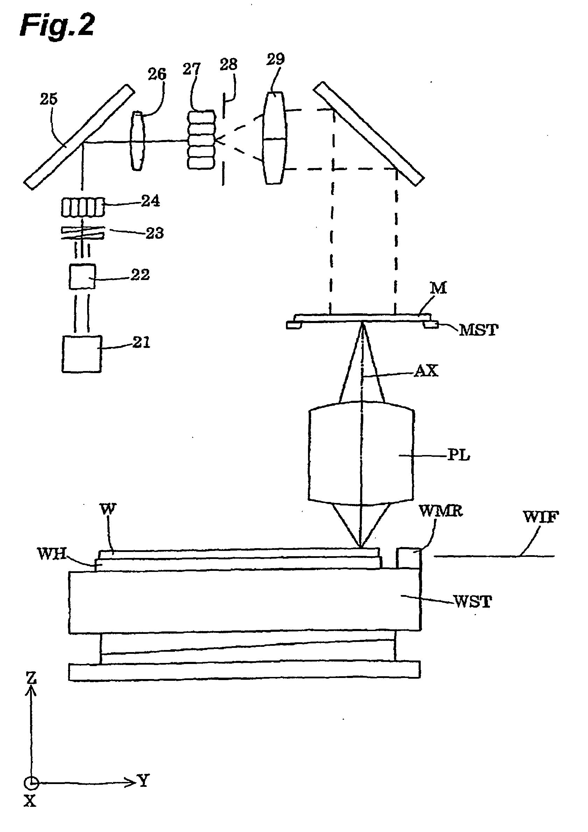

Fig. 1 is a view schematically showing the configuration of an FIA system as an observation apparatus in accordance with an embodiment of the present invention. Fig. 2 is a view schematically showing the configuration of an exposure apparatus mounted with the FIA system as the observation apparatus of Fig. 1. In Fig. 2, Z, Y, and X axes are set in a direction of a normal of a wafer W which is a photosensitive substrate, a direction parallel to the sheet surface or Fig. 2 within the wafer surface, and a direction perpendicular to the sheet surface of Fig- 2 within the wafer surface, respectively.

The exposure apparatus of Fig. 2 comprises, for example, an excimer laser light source for supplying light having a wavelength of 248 nm (KrF) or 193 nm (ArF) as a light source 21 for supplying exposure light (illumination light). A substantially parallel light beam emitted from the light source 21 is shaped by way of a beam shaping optical system (beam expander) 22 into a light beam having a predetermined cross section, and then enters an interference attenuator 23. The interference attenuator 23 functions to reduce the occurrence of interference patterns on a mask M which is an irradiation surface (and consequently on a wafer W). Details of the interferometer attenuator 23 are disclosed, for example, in Japanese Patent Application Laid-Open No. SHO 59-226317.

The light beam from the interference attenuator 23 is transmitted through a first fly's-eye lens 24, so as to formnumbers of light sources on its back focal plane. Light beams from the numbers of light sources are deflected by a vibrating mirror 25 and then, by way of a relay optical system 26, illuminate a second fly's-eye lens 27 in a superposing fashion. Here, the vibrating mirror 25 is a folding mirror rotating about the X axis, and functions to reduce the occurrence of interference patterns in the irradiation surface. Thus, a secondary light source constituted by numbers of light sources is formed at the back focal plane of the second fly's-eye lens 27. A light beam from the secondary light source is restricted by an aperture stop 28 disposed nearby and then uniformly illuminates, by way of a condenser optical system 29, a mask Mhaving a lower surface formed with a predetermined pattern.

The light beam transmitted through the pattern of the mask M forms, by way of a projection optical system PL, a mask pattern image onto the wafer W acting as a photosensitive substrate. By way of a mask holder (not depicted), the mask M is mounted on a mask stage MST. According to an instruction from a main control system (not depicted), the mask stage MST is driven by a mask stage controller (not depicted). Here, the movement of the mask stage M is measured by a mask interferometer (not depicted) and a movable mirror (not depicted) provided on the mask stage MST.

On the other hand, the wafer W is attached by a vacuum chuck to a wafer holder WH on the wafer stage WST. According to an instruction from the main control system (not depicted), the wafer stage WST is driven by a wafer stage controller (not depicted) . Here, the movement of the wafer stage WST is measured by a wafer interferometer WIF and a movable mirror WMP. provided on the wafer stage WST. Thus, batch exposure or scanning exposure is carried out while the wafer W is two-dimensionally driven under control within a plane (XY plane) orthogonal to the optical axis AX of the projection optical system PL, whereby the pattern of the mask M is successively exposed to individual exposure areas of the wafer W.

The exposure apparatus of Fig. 2 also comprises an FIA (Field Image Alignment) system for capturing an image of an alignment mark, i.e., wafer mark, formed in the wafer W mounted on the wafer stage WST and detecting the position of the wafer W in the XY plane according to image information of thus captured wafer mark. Referring to Fig. 1, the FIA system comprises a light source 1 for supplying illumination light having a large wavelength bandwidth. For example, a light source such as halogen lamp can be used as the light source 1. By way of a relay optical system which is not depicted, the illumination light (having a wavelength of 530 nm to 800 nm, for example) from the light source 1 is made incident on a light guide 2 such as optical fiber, for example, and propagates therethrough.

The illumination light emitted from an exit end of the light guide 2 is restricted by an illumination aperture stop 3 having a circular aperture, for example, and then is made incident on a condenser lens 4. The light transmitted through the condenser lens 4 is made incident on an illumination relay lens 5 by way of an illumination field stop (not depicted). The light transmitted through the illumination relay lens 5 is reflected by a half prism 6 and then illuminates, by way of a first objective lens 7, a wafer mark WM formed on the wafer W. Reflected light (including diffracted light) from the illuminated wafer mark WM is made incident on the half prism 6 by way of the first objective lens 7.

The light transmitted through the half prism 6 forms, by way of a second objective lens 8, an image of the wafer mark WM onto an index plate 9. By way of a first relay lens 10, the light from the image of the wafer mark WM is made incident on an XY branching half prism 11. Byway of a second relay lens 12, the light reflected by the XY branching half prism 11 reaches a Y-direction CCD 13. On the other hand, byway of a second relay lens 14, the light transmitted through the XY branching half prism 11 is made incident on an X-direction CCD 15. Thus, on imaging surfaces of the Y-direction CCD 13 and X-direction CCD 15, an image of the wafer mark WM is formed together with an index pattern image of the index plate 9.

Output signals from the Y-direction CCD 13 and X-direction CCD 15 are supplied to a signal processing system 16. The positional information of the wafer mark WM in the XY plane and, consequently, the positional information of the wafer W in the XY plane are obtained in the signal processing system 16 by signal processing (waveform processing) . As in the foregoing, the first objective lens 7, the half prism 6, and the second obj ective lens 8 constitute a first image-forming optical system for forming an intermediate image of the wafer mark WM according to reflected light from the illuminated wafer mark WM.

On the other hand, the first relay lens 10, the XY branching half prism 11, and the second relay lens 12 (or 14) constitute a second image-forming optical system for forming a secondary image of the wafermark WM onto the imaging surface of the Y-direction CCD 13 (or X-direction CCD 15) according to light from the intermediate image of wafer mark WM formed by way of the first image-forming optical system. The first and second image-forming optical systems constitute an image-forming optical system for forming images of the wafer mark WM onto the imaging surfaces of the Y-direction CCD 13 and X-direction CCD 15 according to reflected light from the illuminated wafer mark WM.

The image-forming optical system of the observation apparatus in accordance with this embodiment is designed so as to be able to suppress various aberrations favorably and secure excellent image-forming performances. However, as mentioned above, there are cases where aberrations to be adjusted remain in image-forming optical systems of actually manufactured observation apparatus because of various factors. In such a case, an aberration correction plate 17 is inserted in a parallel optical path between the first objective lens 7 and second objective lens 8 in this embodiment, so as to correct (adjust) residual aberrations of the image-forming optical system. Though the aberration correction plate 17 is inserted between the half prism 6 and first objective lens 7 in Fig. 1, the aberration correction plate 17 may be inserted between the half prism 6 and second objective lens 8 as well. In the following, a first aberration correcting method and, a first manufacturing method of the observation apparatus in accordance with this embodiment will be explained.

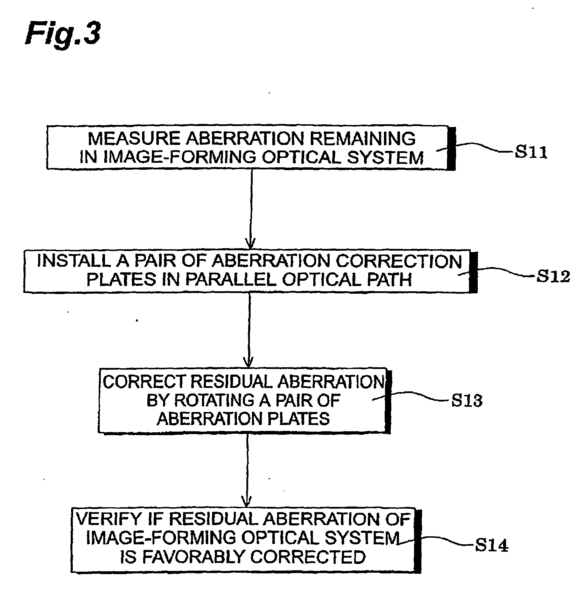

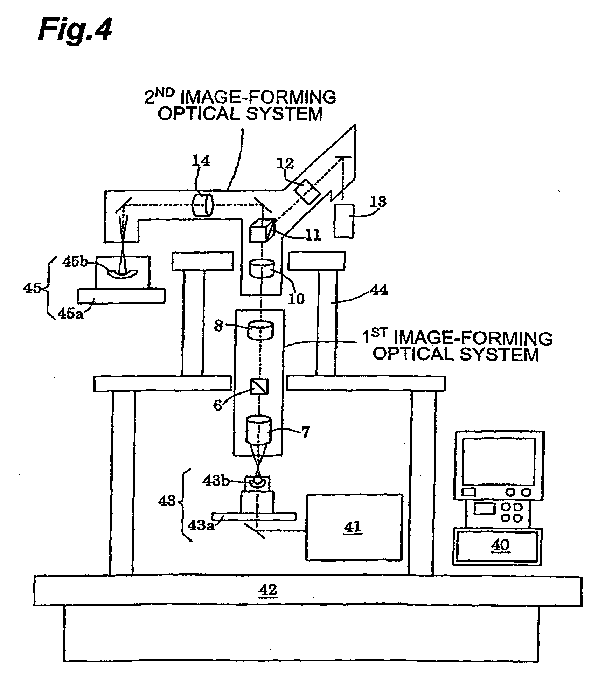

Fig. 3 is a flowchart showing a manufacturing flow in the first method of manufacturing the observation apparatus in accordance with this embodiment. As shown in Fig. 3, the firstmanufacturingmethodmeasures the wave front aberration remaining in an actually made image-forming optical system (S11). Specifically, the interferometer apparatus shown in Fig. 4 is used for measuring the wavefront aberration remaining in the assembled image-forming optical system. In the interferometer apparatus of Fig. 4, a control system 40 and a small interferometer unit 41 are supported on a vibration-proof table 42. The light (e.g., He-Ne laser light having a wavelength of 633 nm) emitted from the interferometer unit 41 under the control of the control system 40 is made incident on a Fizeau lens 43b supported on a Fizeau stage 43a.

Here, the Fizeau stage 43a and the Fizeau lens 43b constitute a Fizeau unit 43. The light reflected by the reference surface of the Fizeau lens 43b becomes reference light, which returns to the interferometer unit 41. On the other hand, the light transmitted through the Fizeau lens 43b becomes measurement light, which is made incident on the image-forming optical systems attached to an attachment table 44. The measurement light thus transmitted through the first image-forming optical system and the second image-forming optical system in the X direction is made incident on a reflecting spherical surface 45b supported on a reflecting spherical surface stage 45a. Here, the reflecting spherical surface stage 45a and the reflecting spherical surface 45b constitute a reflecting spherical surface unit 45.

The measurement light reflected by the reflecting spherical surface 45b returns to the interferometer unit 41 by way of the second image-forming optical system in the X direction, the first image-forming optical system, and the Fizeau lens 43b. Thus, according to the phase difference between the reference light and measurement light returned to the interferometer unit 41, the wavefront aberration remaining in the X-direction image-forming optical system, which is an optical system to be inspected, is measured. Subsequently, the γ-direction CCD 13 is removed, and the reflecting spherical surface unit 45 is positioned with respect to the second image-forming optical system in the Y direction, whereby the wavefront aberration remaining in the Y-direction image-forming optical system is measured as in the case of the X-direction image-forming optical system.

Besides the measurement technique using an interferometer, a mark formed on an appropriate surface of a specimen may be captured by way of an image-forming optical system, whereby the wavefront aberration remaining in the image-forming optical system can be measured based on the image information of the mark, for example. In this embodiment, for correcting the residual wavefront aberration of the image-forming optical system, a pair of aberration correction plates each having one surface formed into a Zernike aspheric surface are installed in a parallel optical path between the first objective lens 7 and second objective lens 8 (S12).

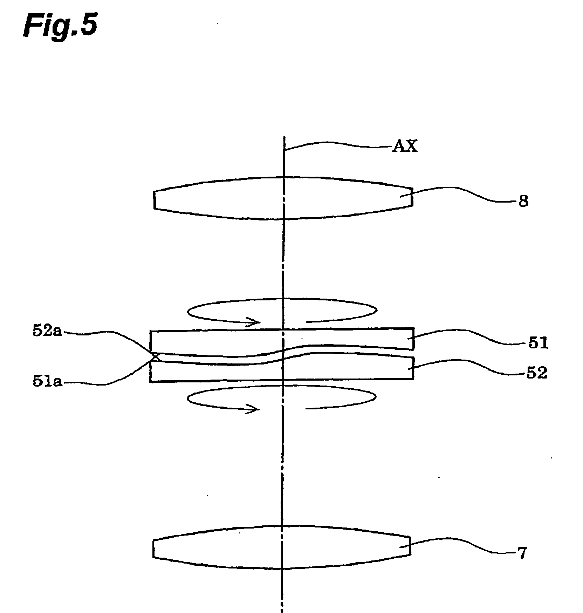

Fig. 5 is a view showing a state where a pair of aberration correction plates are installed in the parallel optical path between the first and second objective lenses. As shown in Fig. 5, each of the pair of aberration correction plates 51 and 52 installed in the parallel optical path between the first objective lens 7 and second objective lens 8 has a plane parallel form, whereas their opposing surfaces 51a and 52a are shaped into the same Zernike aspheric form. Also, each of the aberration correction plates 51 and 52 is configured so as to be rotatable about the optical axis AX. In the following, basic matters concerning Zernike aspheric surfaces will be explained.

In general, aspheric surfaces can be expressed by Zernike polynomials. As the expression of Zernike polynomials, polar coordinates are used as a coordinate system, and a Zernike cylindrical function system is used as an orthogonal function system. First, polar coordinates are defined on an aspheric surface, so as to express the aspheric form as $M(\rho, \theta)$. Here, $\rho$ is the normalized pupil radius taking the radius of the aspheric surface as 1, and $\theta$ is the directional angle of radius vector. Then, using Zernike cylindrical function system $zn(\rho,\theta)$, the aspheric surface $M(\rho, \theta)$ is expanded as shown in the following expression (1):

$$M(\rho, \theta) = \sum CnZn(\rho, \theta)$$
$$= C1 \cdot Z1(\rho, \theta) + C2 \cdot Z2(\rho, \theta) \qquad (1)$$
$$\cdots + Cn \cdot Zn(\rho, \theta)$$

where Cn is the expansion coefficient. In the Zernike cylindrical function system Zn $(\rho,\theta)$, cylindrical function system Z1 to Z36 according to terms 1 to 36 are as follows:

n: $Zn(\rho,\theta)$
1: $1$
2: $\rho\cos\theta$
3: $\rho\sin\theta$
4: $2\rho^2-1$
5: $\rho^2\cos2\theta$
6: $\rho^2\sin2\theta$
7: $(3\rho^2-2)\rho\cos\theta$
8: $(3\rho^2-2)\rho\sin\theta$
9: $6\rho^4-\rho^2+1$
10: $\rho^3\cos3\theta$
11: $\rho^3\sin3\theta$
12: $(4\rho^2-3)\rho^2\cos2\theta$
13: $(4\rho^2-3)\rho^2\sin2\theta$
14: $(10\rho^4-12\rho^2+3)\rho\cos\theta$
15: $(10\rho^4-12\rho^2+3)\rho\sin\theta$
16: $20\rho^6-30\rho^4+12\rho^2-1$
17: $\rho^4\cos4\theta$
18: $\rho^4\sin4\theta$
19: $(5\rho^2-4)\rho^3\cos3\theta$
20: $(5\rho^2-4)\rho^3\sin3\theta$
21: $(15\rho^4-20\rho^2+6)\rho^2\cos2\theta$
22: $(15\rho^4-20\rho^2+6)\rho^2\sin2\theta$
23: $(35\rho^6-60\rho^4+30\rho^2-4)\rho\cos\theta$

24: $(35\rho^6-60\rho^4+30\rho^2-4)\rho\sin\theta$

25: $70\rho^8-140\rho^6+90\rho^4-20\rho^2+1$

26: $\rho^5\cos5\theta$

27: $\rho^5\sin5\theta$

28: $(6\rho^2-5)\rho^4\cos4\theta$

29: $(6\rho^2-5)\rho^4\sin4\theta$

30: $(21\rho^4-30\rho^2+10)\rho^3\cos3\theta$

31: $(21\rho^4-30\rho^2+10)\rho^3\sin3\theta$

32: $(56\rho^6-104\rho^4+60\rho^2-10)\rho^2\cos2\theta$

33: $(56\rho^6-104\rho^4+60\rho^2-10)\rho^2\sin2\theta$

34: $(126\rho^8-280\rho^6+210\rho^4-60\rho^2+5)\rho\cos\theta$

35: $(126\rho^8-280\rho^6+210\rho^4-60\rho^2+5)\rho\sin\theta$

36: $252\rho^{10}-630\rho^8+560\rho^6-210\rho^4+30\rho^2-1$

In the present invention, the aspheric surface defined by the expansion coefficient Cn and cylindrical function system Zn according to term n is expressed as the term n aspheric surf ace. In this case, term 2 to 9 aspheric surfaces generate lower-order aberration components of wavefront aberration, whereas term 10 to 36 aspheric surfaces generate higher-order aberration components of wavefront aberration. On the other hand, terms including no θ, i.e., terms 4, 9, 16, 25, and 36 aspheric surfaces, generate rotationally symmetric components of wavefront aberration. The rotationally symmetric components refer to those in which a value at a certain coordinate point equals a value at a coordinate point obtained when the former coordinate point is rotated by a given angle about the center of the aspheric surface.

Terms including trigonometric function of odd multiples of the directional angle of radius vector θ, such as sinθ (or cosθ) and sin3θ (or cos3θ), i.e., term 2, 3, 7, 8, 10, 11, 14, 15, 19, 20, 23, 24, 26, 27, 30, 31, 33, and 34 aspheric surfaces, generate odd-symmetric components of wavefront aberration. The odd-symmetric components refer to those in which a value at a certain coordinate point equals a value at a coordinate point obtained when the former coordinate point is rotated by an odd submultiple of 360° about the center of the aspheric surface.

Terms including trigonometric function of even multiples of the directional angle of radius vector θ, such as sin2θ (or cos2θ) and sin4θ (or cos4θ), i.e., term 5, 6, 12, 13, 17, 18, 21, 22, 28, 29, 32, and 33 aspheric surfaces, generate even-symmetric components of wavefront aberration. The even-symmetric components refer to those in which a value at a certain coordinate point equals a value at a coordinate point obtained when the former coordinate point is rotated by an even submultiple of 360° about the center of the aspheric surface.

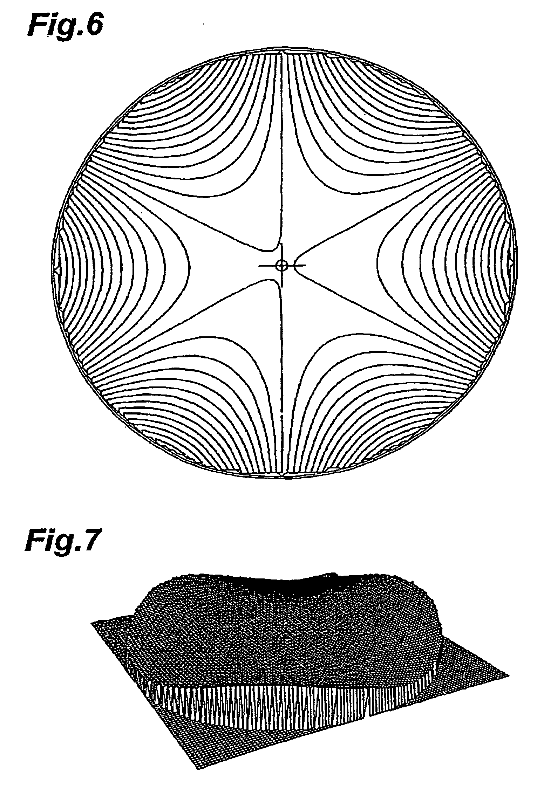

Thus, higher-order aberration components of wavefront aberration can be corrected by using a pair of aberration correction plates 51 and 52 formed into the term 10 aspheric surface (or term 11 aspheric surface). Fig. 6 shows the Zernike term 10 aspheric surface by a contour map. Fig. 7 is a view three-dimensionally showing undulations of the Zernike term 10 aspheric surface with exaggeration. Here, in the initial state where the aberration correction plates 51 and 52 are placed such that their aspheric surfaces 51a and 52a are complementary to each other, a pair of aberration correction plates 51 and 52 function as plane parallel plates and thus cannot correct the wavefront aberration remaining in the image-forming optical system. More specifically, the Zernike term 10 is expressed as $C_{10}\rho^3\cos3\theta$, whereby the aspheric surfaces 51a and 52a have the same form. When the aberration correction plates 51 and 52 (aspheric surfaces 51a and 52a) are placed so as to oppose each other, one of the coordinate axis rotates by 180°, thus substantially yielding $-C_{10}\rho^3\cos3\theta$. As a consequence, their aberration components cancel each other out.

However, higher-order aberration components of wavefront aberration occur by way of a pair of aberration correction plates 51 and 52 when one of them is rotated. In other words, higher-order aberration components of wavefront aberration can be corrected in a state where one of a pair of aberration correction plates 51 and 52 is rotated. Namely, in this embodiment, one of a pair of aberration correction plates 51 and 52 is rotated so as to generate wavefront aberration, and then the aberration correction plates 51 and 52 are rotated together, so as to adjust the direction of wavefront aberration, thereby correcting the higher-order aberration components of wavefront aberration remaining in the image-forming optical system (S13). For example, when one of them is rotated from their canceling state by 60° about the optical axis substantially within a plane orthogonal to the optical axis, they can substantially function as a surface with $2C_{10}\rho^3\cos3\theta$. The maximum aberration generation amount is obtained in this state. Adjusting the amount of rotation (the relative rotational angle between the aberration correction plates 51 and 52) can substantially change the aberration generation amount within the range of 0 to $2C_{10}\rho^3\cos3\theta$. After the aberration generation amount is determined according to the Zernike terms 10 and 11 remaining in the image-forming optical system, both of the aberration correction plates 51 and 52 can be rotated together so as to adjust their angle, thereby canceling out (nullifying) the aberration of the image-forming optical system, i.e., Zernike terms 10 and 11.

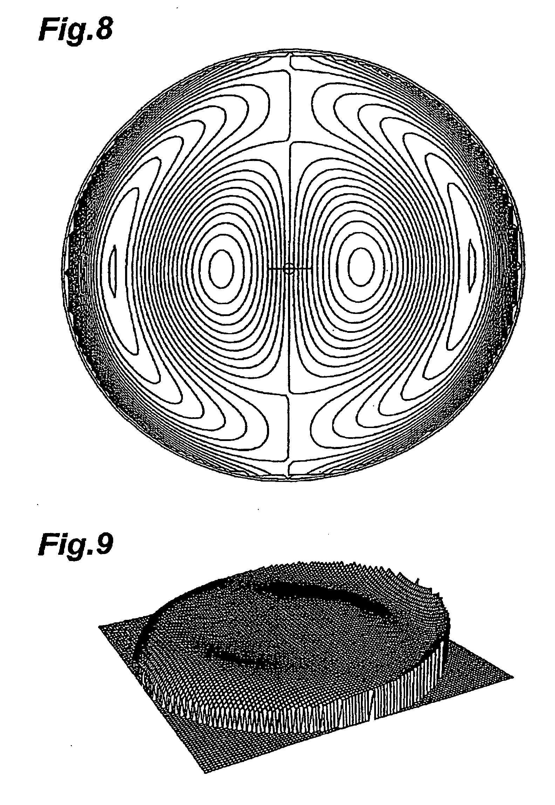

Using a pair of aberration correction plates 51 and 52 formed into the term 14 aspheric surface (or term 15 aspheric surface), higher-order coma aberration components of wavefront aberration remaining in the image-forming optical system can be corrected. Fig. 8 shows the Zernike term 14 aspheric surface by a contour map. Fig. 9 is a view three-dimensionally showing undulations of the Zernike term 14 aspheric surface with exaggeration. Using a pair of aberration correction plates 51 and 52 formed into the term 12 aspheric surface (or term 13 aspheric surface), higher-order astigmatic components of wavefront aberration remaining in the image-forming optical system can be corrected.

Here, astigmatic components refer to components in which the difference between the wavefront aberration component proportional to the squared distance from the optical axis in a certain meridional plane and the wavefront aberration component proportional to the squared distance from the optical axis in a plane orthogonal thereto is maximized. Using a pair of aberration correction plates 51 and 52 formed into the term 28 aspheric surface, the sixth-order astigmatic component of wavefront aberration remaining in the image-forming optical system can be corrected. In this case, however, the sixth-order spherical aberration component can be corrected for only two directions orthogonal to each other.

Thus, in the first manufacturing method, a pair or a plurality of pairs of aberration correction plates, such as those formed into the terms 10, 12, 14, and 28 spherical forms, for example, are installed in an optical path, and one of each pair of aberration correction plates is rotated, so as to correct higher-order aberration components of wavefront aberration remaining in the image-forming optical system. Here, it is needless to mention that lower-order aberration components of wavefront aberration are corrected by a normal optical adjustment before correcting the higher-order aberration components of wavefront aberration. It is also desirable that lower-order aberration components generated by errors in manufacture be expelled after correcting the higher-order aberration components.

Finally, it is verified whether the residual aberration of the image-forming optical system is favorably corrected (adjusted), for example, by an action of a pair or a plurality of pairs of aberration correction plates (S14). In this case, the interferometer apparatus shown in Fig. 4 can be used for measuring wavefront aberration of the whole image-forming optical system, so as to verify whether the aberration of the image-forming optical system is corrected or not. If it is verified that the residual aberration of the image-forming optical system is not corrected favorably, the installed aberration correction plates are adjusted by rotating or replaced by new aberration correction plates, adding new aberration correction plates, or additionally adjusting lower-order aberration components when necessary, until the residual aberration of the image-forming optical system is corrected favorably. If it is verified that the residual aberration of the image-forming optical system is favorably corrected, a series of manufacturing steps concerning the first manufacturing method will be terminated.

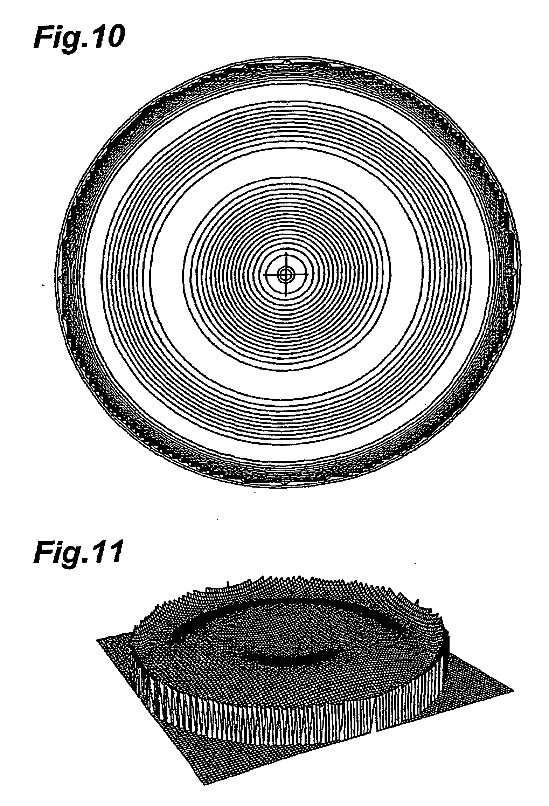

Meanwhile, installing a single aberration correction plate having one surface formed into the term 16 aspheric surface in a parallel optical path between the first objective lens 7 and second objective lens 8 can correct the sixth-order spherical aberration component of wavefront aberration remaining in the image-forming optical system. In this case, it is not necessary for the aberration correction plate installed in the optical path to be rotated about the optical axis AX. When the aberration correction plate is installed in reverse, the polarity of aberration correction amount canbe inverted. Fig. 10 shows the Zernike term 16 aspheric surface by a contour map. Fig. 11 is a view three-dimensionally showing undulations of the Zernike term 16 aspheric surface with exaggeration.

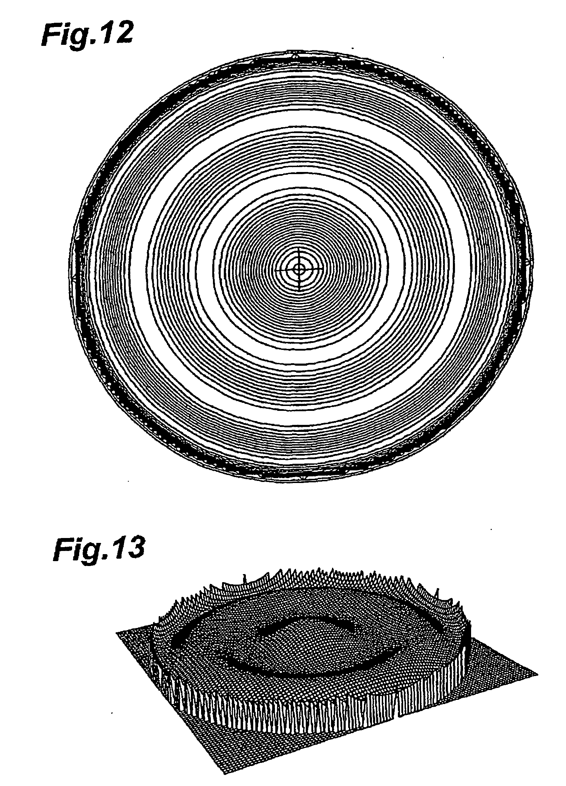

Installing a single aberration correction plate having one surface formed into the term 25 aspheric surface can correct the eighth-order spherical aberration component of wavefront aberration remaining in the image-forming optical system. In this case, it is not necessary for the aberration correction plate installed in the optical path to be rotated about the optical axis AX. When the aberration correction plate is installed in reverse, the polarity of aberration correction amount can be inverted. Fig. 12 shows the Zernike term 25 aspheric surface by a contour map. Fig. 13 is a view three-dimensionally showing undulations of the Zernike term 25 aspheric surface with exaggeration.

Therefore, as a first modified example of the first manufacturing method, one or a plurality of individual aberration correction plates such as those formed into the term 16 or 25 aspheric surface, for example, can be installed in the optical path in place of or in addition to a pair or a plurality of pairs of aberration correction plates, so as to correct higher-order rotationally symmetric components remaining in the image-forming optical system. Since the Zernike terms 16 and 25 are rotationally symmetric components and do not change even when the aberration correction plate is rotated, an aberration correction plate having the term 16 and/or 25 aspheric form may be attached to the planar side of a pair of aberration correction plates to be adjusted by rotating. In this case, one surface of the aberration correction plate is formed into the term 16 and/or 25 aspheric surface, whereas the other is planar. Also, an aberration correction plate having the term 16 and/or 25 aspheric form may be formed on the planar sides of a pair of aberration correction plates to be adjusted by rotating. These configurations can reduce the substantial number of parts, thereby achieving a simplification.

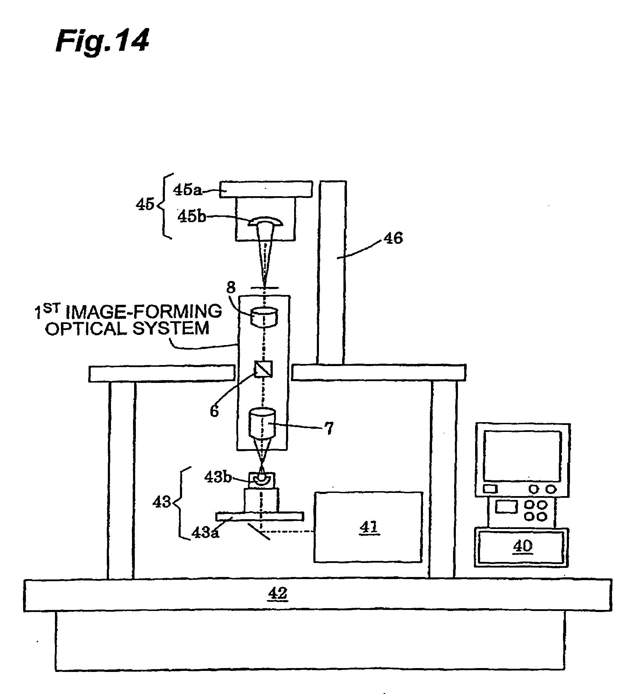

Though the interferometer apparatus shown in Fig. 4 is used for measuring the wavefront aberration of the whole image-forming optical system, a second modified example may be configured such that an interferometer apparatus having a configuration similar to that of the interferometer apparatus shown in Fig. 4 is used as shown in Fig. 14, so as to measure the wavefront aberration of the first image-forming optical system constituting a part of the image-forming optical system. In the interferometer apparatus of Fig. 14, only the first image-forming optical system is attached to an attachment table 46, whereby the wavefront aberration of the first image-forming optical system by itself is measured. This is a simple measuring method taking account of the fact that the correction of residual aberration of the first image-forming optical system including the first objective lens 7 and second objective lens 8 is dominant in the correction of residual aberration of the image-forming optical system.

Further, after the wavefront aberration of the image-forming optical system is measured, an aberration correction plate is installed in the optical path in the first manufacturing method in order to correct the residual aberration obtained by measurement. However, a third modified example may be configured such that higher-order aberration components of wavefront aberration supposed to remain in the image-forming optical system are estimated, and a pair or a plurality of pairs of aberration plates or one oraplurality of individual aberration correction plates are incorporated in the image-forming optical system beforehand according to the estimation. In this case, while measuring the wavefront aberration of the image-forming optical system (or first image-forming optical system), a pair or a plurality of pairs of aberration correction plates can be adjusted by rotating, so as to correct the residual aberration of the image-forming optical system.

Though the first manufacturing method uses an aberration correction plate having one surface formed into a Zernike aspheric form, it is not restrictive, whereby an aberration correction plate having one surface or both surfaces formed into other common aspheric forms can be used as well.

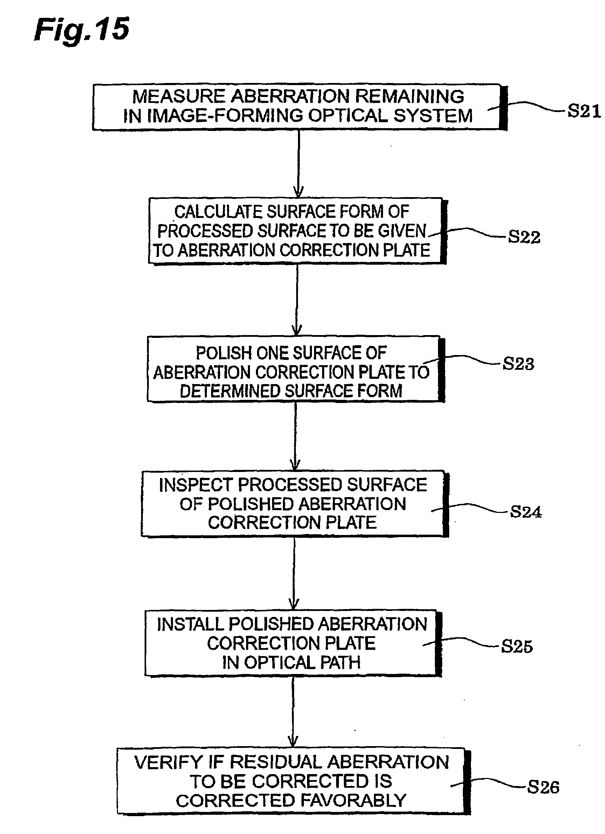

Fig. 15 is a flowchart showing a manufacturing flow in a second manufacturing method of the observation apparatus in accordance with this embodiment. As shown in Fig. 15, the wavefront aberration remaining in the actually manufactured image-forming optical system is measured in the second manufacturing method too (S21). Specifically, for example, the interferometer apparatus shown in Fig. 4 is used, so as to measure the wavefront aberration remaining in the whole image-forming optical system assembled. Alternatively, for example, the interferometer apparatus of Fig. 14 is used, so as to measure the wavefront aberration remaining in the first image-forming optical system alone. A mark formed on an appropriate surface of a specimen may be captured by way of an image-forming optical system, so as to measure the wavefront aberration remaining in the image-forming optical system according to thus obtained image information of the mark in the second manufacturing method as well.

Subsequently, according to data of higher-order aberration components of wavefront aberration determined by the measuring step S21 for measuring the residual aberration of the image-forming optical system, the surface form of a processed surface to be imparted to an aberration correction plate is calculated, for example, by a computer-aided simulation (S22). Preferably, when calculating the surface form, a simulation is carried out according to actually measured data of individual optical members constituting the image-forming optical system. Namely, it is preferred that the surface form of the processed surface be calculated by using actually measured data such as surface form (curvature), center thickness, and axial air space of each of optical surfaces of the individual optical members constituting the image-forming optical system. It is also preferred that, when necessary, the surface form of the processed surface be calculated by a simulation using actually measured data of optical characteristic distributions such as refractive index distributions of the individual optical members constituting the image-forming optical system.

Here, the surface form of each optical member such as a lens component can be measured by using a Fizeau interferometer. The center thickness of each optical member can be determined according to a known appropriate optical measurement technique, for example. The axial air space of each optical member can be determined by measuring a holding member for holding each optical member and the like, for example. The refractive index distribution of each optical member can be determined when the transmitted wavefront is measured by a Fizeau interferometer, for example, in an unprocessed plane parallel plate (disc plate) cut out from an ingot. Usually, the measured refractive index distribution is not a distribution along the thickness direction of the unprocessed plane parallel plate, but a two-dimensional distribution along the plane parallel direction thereof.

Subsequently, using a dedicated polisher, for example, one surface of the aberration correction plate is polished into a predetermined surface form (S23) according to the result of calculation in the surface form calculating step S22. Preferably, both surfaces of the aberration correction plate are polished so as to become planar. The polished processed surface of the aberration correction plate is provided with a predetermined coat (antireflection film or the like) when necessary. Subsequently, the polished processed aberration correction plate is inspected (S24). In the processed surface inspecting step S24, the wavefront transmitted through the aberration correction plate is measured by using a Fizeau interferometer, for example, and the aberration correction amount for the aberration correction plate is measured according to the measured transmitted wavefront. In this case, performances of the aberration correction plate including the surface accuracy of the processed surface and the like are evaluated. Then, the aberration assumed to occur in the image-forming optical system according to the setting of the processed aberration correction plate is calculated by a simulation using actually measured data such as the surface form, center thickness, axial air space, and refractive index distribution of each of the optical surfaces of the optical members in the image-forming optical system including the aberration correction plate.

After it is verified that the aberration calculated by the simulation using the above-mentioned actually measured data can fully cancel the residual aberration to be corrected, the polished aberration correction plate is installed at a predetermined position of the image-forming optical system, i.e., in a parallel optical path between the first objective lens 7 and second objective lens 8 (S25) . If it is verified that the aberration calculated by the simulation using the above-mentioned actually measured data cannot fully cancel the residual aberration to be corrected, on the other hand, the processed surface form calculating step S22, aberration correction plate polishing step S23, and processed surface inspecting step S24 will be repeated as necessary.

Finally, in the state where the polished aberration correction plate is installed in the optical path, the residual aberration of the image-forming optical system is measured again by the interferometer apparatus shown in Fig. 4, for example, so as to verify whether the residual aberration to be corrected is favorably corrected or not (S26) If it is determined that the residual aberration to be corrected is not corrected favorably, the processed surface form calculating step S22, aberration correction plate polishing step S23, processed surface inspecting step S24, and aberration correction plate installing step S25 will be repeated as necessary. If it is verified that the residual aberration to be corrected is corrected favorably, a series of manufacturing steps concerning the second manufacturing method will be terminated.

The processed surface inspecting step S24 is not an essential step in the second manufacturing method in this embodiment, and may be omitted as appropriate. Also, using actually measured data of each optical member in the processed surface calculating step S22 is not essential in this embodiment, whereby the surface form of the processed surface can be calculated by using design data of each optical member, for example.

Though an example in which the image-forming optical system is designed to have a configuration including no aberration correction plate is explained in the second manufacturing method, a first modified example may be configured such that the image-forming optical system includes an aberration correction plate. In this case, in the state where an unprocessed aberration correction plate is installed in a parallel optical path between the first objective lens 7 and second objective lens 8, the wavefront aberration remaining in the image-forming optical system is measured. Alternatively, the wavefront aberration remaining in the image-forming optical systemmaybemeasured in a state where a measurement member having the same optical characteristics (form, material, and the like) as with the unprocessed aberration correction plate is installed in the parallel optical path in place of the aberration correction plate.

In the case where the residual aberration of the image-forming optical system was measured by using the unprocessed aberration correction plate, the unprocessed aberration correction plate installed in the image-forming optical system is taken out and polished. Subsequently, the polished aberration correction plate is returned to the position where the unprocessed aberration correction plate was installed. In the case where a dummy measurement member was used for measuring the residual aberration of the image-forming optical system, on the other hand, it is not necessary to remove the aberration correction plate from the image-forming optical system, and the unprocessed aberration correction plate prepared beforehand is polished into a predetermined surface form. Then, after the measurement member is removed from the image-forming optical system, the polished aberration correction plate is installed so as to be inserted in the optical path of the image-forming optical system. Namely, the polished aberration correction plate is set to the position where the dummy measurement member was installed.

Though an aberration correction plate is processed into an aspheric form necessary for correcting the residual aberration obtained by the measurement in the second manufacturing method, a second modified example can be configured such that an aberration correction plate having one surface formed into a specific Zernike aspheric form is inserted into the optical path by a-so-called Zernike fitting technique in order to correct necessary higher-order aberration components in the residual wavefront aberration. In the second modified example, one or a plurality of aberration correction plates are selected from numbers of prepared aberration correction plates formed into various aspheric forms and are set into a parallel optical path between the first objective lens 7 and second objective lens 8.

Specifically, when the sixth-order spherical aberration component in the residual wavefront aberration is desired to be corrected, for example, an aberration correction plate having one surface formed into the Zernike term 16 aspheric surface is set into the optical path. When the eighth-order spherical aberration component in the residual wavefront aberration is desired to be corrected, for example, an aberration correction plate having one surface formed into the Zernike term 25 aspheric surface is set in the optical path. When the astigmatic component in the residual wavefront aberration is desired to be corrected, for example, an aberration correction plate having one surface formed into the Zernike term 12 aspheric surface (or term 13 aspheric surface) is set into the optical path. When the astigmatic component in the residual wavefront aberration is desiredtobe corrected, for example, an aberration correction plate having one surface formed into the Zernike term 14 aspheric surface (or term 15 aspheric surface) is set into the optical path.

Though the second manufacturing method corrects the residual aberration by processing the aberration correction plate, a third modified example may be configured so as to correct the residual aberration by processing one or both of surfaces of a particular lens component into a predetermined aspheric form in a plurality of lens components constituting the image-forming optical system.

Though the first and second manufacturing methods install an aberration correction plate in the parallel optical path between the first objective lens 7 and second objective lens 8, the aberration correction plate may be installed in other parallel optical path and other appropriate optical path without being restricted thereto.

Though the first and second manufacturing methods measure wavefront aberration by using an He-Ne laser light having a wavelength of 633 nm, the light source 1 used in the FIA system supplies illumination light having a wavelength of 530 nm to 800 nm. Therefore, it is preferred in this embodiment that the chromatic aberration occurring in the image-forming optical system be estimated according to actually measured data such as surface form (curvature) , center thickness, and axial air space of each of optical surfaces of the individual optical members constituting the image-forming optical system of the FIA system, and optical adjustment including the replacement of optical members and the like be carried out in order to correct the estimated chromatic aberration.

The first and second manufacturing methods manufacture numbers of optical members each constituting the image-forming optical system of the FIA system, and individual optical members chosen from thus manufactured optical members are combined so as to assemble the image-forming optical system. Therefore, it is preferred in this embodiment that the chromatic aberration occurring in the image-forming optical system obtained by combining the individual optical members be estimated according to actually measured data such as surface form (curvature), center thickness, and axial air space of each of optical surfaces of the individual optical members constituting the image-forming optical system of the FIA system, and the image-forming optical system be assembled by combining the optical members selected such that the aberration occurring in the image-forming optical system becomes relatively small according to the result of estimation.

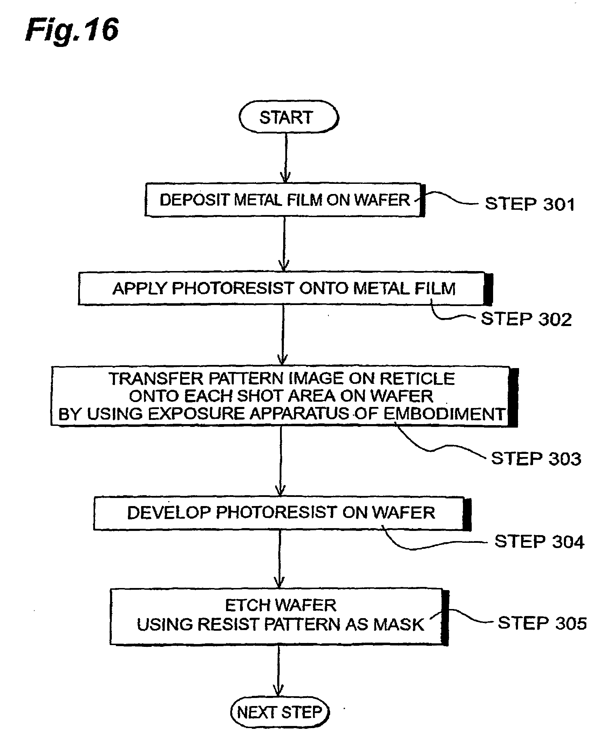

In this embodiment, a mask (reticle) maybe illuminated by an illumination system (illumination step) , anda transfer pattern formed on the mask may be exposed to a photosensitive substrate by a projection optical system (exposure step), whereby a microdevice (semiconductor device, imaging device, liquid crystal display device, thin-film magnetic head, or the like) can be made. An example of technique for yielding a semiconductor device as a microdevice by forming a predetermined circuit pattern on a wafer or the like acting as a photosensitive substrate by using the exposure apparatus in accordance with this embodiment will now be explained with reference to the flowchart of Fig. 16.

First, at step 301 in Fig. 16, a metal film is vapor-deposited on 1 lot of wafers. At subsequent step 302, a photoresist is applied onto the 1 lot of wafers. Then, at step 303, the exposure apparatus of this embodiment is used so that an image of a pattern on the mask is successively exposed and transferred to each shot area on the 1 lot of wafers by way of its projection optical system (projection optical module) . Thereafter, the photoresist on the 1 lot of wafers is developedat step 304, and then etching is carried out on the 1 lot of wafers while using the resist pattern as a mask at step 305, whereby the circuit pattern corresponding to the pattern on the mask is formed in each shot area on each wafer. Subsequently, forming of circuit patterns on upper layers and the like are carried out, whereby a device such as a semiconductor device is made. The above-mentioned method of manufacturing a semiconductor device can yield a semiconductor device having a very thin circuit pattern with a favorable throughput.

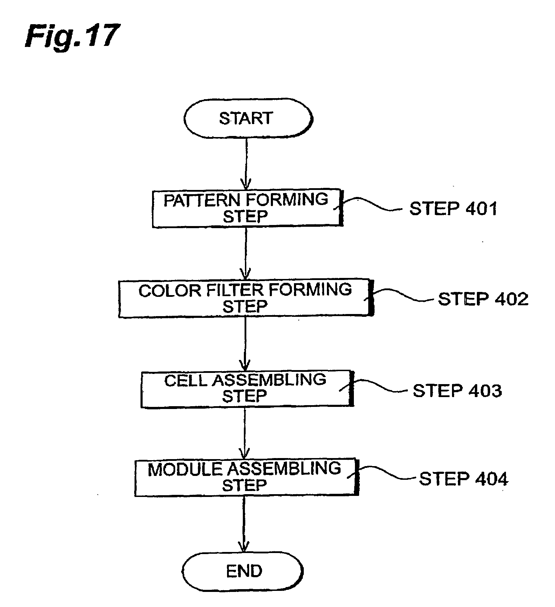

The exposure apparatus of this embodiment can also yield a liquid crystal display device as a microdevice by forming a predetermined pattern (circuit pattern, electrode pattern, or the like) on a plate (glass substrate). An example of technique in this case will now be explained with reference to the flowchart of Fig. 17. In Fig. 17, at a pattern forming step 401, so-called photolithography is carried out, in which the exposure apparatus of this embodiment is used for transferring and exposing a mask pattern to a photosensitive substrate (glass substrate coated with a resist, or the like). This photolithography step forms a predetermined pattern including numbers of electrodes and the like on the photosensitive substrate. Then, the substrate exposed to light is subjected to individual steps such as developing, etching, and reticle releasing steps, so as to form a predetermined pattern on the substrate, and the flow shifts to a subsequent color filter forming step 402.

Next, the color filter forming step 402 forms a color filter in which numbers of sets of three dots corresponding to R (Red) , G (Green), and B (Blue) are arranged in a matrix or a plurality of sets of filters of three stripes of R, G, and B are arranged in a horizontal scanning line direction. After the color filter forming step 402, a cell assembling step 403 is carried out. In the cell assembling step 403, using the substrate having a predetermined pattern obtained by the pattern forming step 401, the color filter obtained by the color filter forming step 402, and the like, a liquid crystal panel (liquid crystal cell) is assembled. For example, in the cell assembling step 403, a liquid crystal is injected between the substrate having a predetermined pattern obtained by the pattern forming step 401 and the color filter obtained by the color filter forming step 402, so as to make a liquid crystal panel (liquid crystal cell) .

Thereafter, at a module assembling step 404, parts such as an electric circuit for causing the assembled liquid crystal display panel (liquid crystal cell) to carry out display operations and a backlight are attached, so as to complete a liquid crystal display device. The above-mentioned method of manufacturing a liquid crystal display device can yield a liquid crystal display device having a very thin circuit pattern. with a favorable throughput.

Though the above-mentioned embodiment employs the present invention in the FIA system mounted to an exposure apparatus, it is not restrictive, whereby the present invention is also applicable to other observation apparatus mounted to exposure apparatus, and common observation apparatus unrelated to exposure apparatus. For example, the present invention is applicable to alignment systems for detecting reticle (mask) marks disclosed in Japanese Patent Application Laid-Open No. HEI 7-321022 (and its corresponding U.S. Patent No. 5,552,892), Japanese Patent Application Laid-Open No. HEI 8-75415 (and its corresponding U.S. Patent No. 5,552,892), Japanese Patent Application Laid-Open No. 2000-252182, and the like; aligning accuracy measuring apparatus and pattern interval size measuring apparatus disclosed in Japanese Patent Application Laid-Open No. HEI 6-58730, Japanese Patent Application Laid-Open No. HEI 7-71918, Japanese Patent Application Laid-Open No. HEI 10-122814, Japanese Patent Application Laid-OpenNo. HEI 10-122820, and Japanese Patent Application Laid-Open No. 2000-258119; aberration measuring apparatus of Shack-Hartman type projection optical systems and image detection type aberration measuring apparatus disclosed in WO 99/60631 Publication (and its corresponding European Patent Application Laid-Open No. 1079223) and WO 2000/55890 Publication; and the like. The present invention is also applicable to microscopes, foreign matter inspecting apparatus of image detection type, defect detecting apparatus, and the like.

Though the above-mentioned embodiment employs the present invention in an exposure apparatus equipped with an excimer laser light source, it is not restrictive, whereby the present invention is applicable to exposure apparatus having other light sources such as ultrahigh-pressure mercury lamps supplying g-line (436 mn) or i-line (365 nm) , light sources supplying $F_2$ laser (157 nm) and harmonics of metal vapor lasers and YAG laser, and the like, for example. Without being restricted to exposure apparatus for manufacturing semiconductors and exposure apparatus for manufacturing liquid crystals for exposing liquid crystal display device patterns, the exposure apparatus can widely be applied to exposure apparatus for thin-film magnetic heads, exposure apparatus for making projection originals for exposure apparatus disclosed inWO 99/34255 Publication (and its corresponding European Patent Application Laid-Open No. 1043625) and WO 99/50712 Publication (and its corresponding European Patent Application Laid-Open No.1083462), and the like.

Though the above-mentioned embodiment employs the present invention in alignment apparatus and observation apparatus of image detection type which detect an image of an object by way of image-forming optical systems, the present invention is also applicable to alignment apparatus of diffracted light detection type disclosed in WO 98/39689 Publication (and its corresponding European Patent Application Laid-Open No. 906590), for example.

**Industrial Applicability**

As explained in the foregoing, the observation apparatus of the present invention and the method of manufacturing the same can favorably correct residual aberrations including higher-order components of wavefront aberration, for example, by rotating one of a pair of aberration correction plates installed in a parallel optical path, so as to generate wavefront aberration, and then rotating both of the aberration correction plates together, so as to adjust the direction of wavefront aberration.

Therefore, when the observation apparatus of the present invention is mounted to an exposure apparatus, favorable exposure can be carried out by aligning a mask and a photosensitive substrate with high accuracy, for example, by using the observation apparatus exhibiting high optical performances by favorably correcting the residual aberration. Also, the exposure apparatus equipped with the observation apparatus having high optical performances can be used, so as to make a favorable microdevice by favorable exposure.

**Claims**

1.  An observation apparatus for observing an image of a surface of a specimen formed by way of an image-forming optical system, comprising a correction plate disposed in an optical path of said image-forming optical system;
    at least one surface of said correction plate being shaped into apredetermined form for correcting an aberration remaining in said image-forming optical system.

2.  The observation apparatus according to claim 1,
    wherein said image-forming optical system comprises a first objective lens disposed on the side of said surface of the specimen, and a second objective lens disposed with a gap from said first objective lens, said image-forming optical system forming by way of said first and second objective lenses an image of said surface of the specimen; and
    whereinsaidcorrectionplateisdisposedinaparallel optical path between said first and second objective lenses .

3.  The observation apparatus according to claim 2,
    wherein said correction plate comprises a first correction plate disposed on the side of said surface of the specimen, and a second correction plate disposed with a gap from said first correction plate.

4.  The observation apparatus according to claim 3,
    wherein one surface of said first correction plate is shaped into an aspheric form;
    wherein one surface of said second correction plate is shaped into the same aspheric form as that of said one surface of said first correction plate; and

wherein said one surface of said first correction plate and said one surface of said second correction plate are disposed so as to oppose each other.

5. The observation apparatus according to claim 4,
wherein each of said first and second correction plates is rotatable about an optical axis of said image-forming optical system.

6. The observation apparatus according to claim 1,
wherein said correction plate comprises a first correction plate disposed on the side of said surface of the specimen, and a second correction plate disposed with a gap from said first correction plate.

7. The observation apparatus according to claim 6,
wherein one surface of said first correction plate is shaped into an aspheric form;
wherein one surface of said second correction plate is shaped into the same aspheric form as that of said one surface of said first correction plate; and
wherein said one surface of said first correction plate and said one surface of said second correction plate are disposed so as to oppose each other.

8. The observation apparatus according to claim 7,
wherein each of said first and second correction plates is rotatable about an optical axis of said image-forming optical system.

9. An observation apparatus for observing an image of a surface of a specimen formed by way of an image-forming optical system,
at least one of a plurality of optical surfaces which constitute said image-forming optical system being shaped into a predetermined form for correcting an aberration remaining in said image-forming optical system.

10. A method of manufacturing the observation apparatus according to claim 9, said method comprising:

an aberration measuring step of measuring a residual aberration remaining in said image-forming optical system; and
a correcting step of correcting said residual aberration by rotating each of said first and second correctionplates about an optical axis of said image-forming optical system.

11. The manufacturing method according to claim 10,
wherein in said aberration measuring step said residual aberration remaining in said image-forming optical system is measured by using an interferometer.

12. The manufacturing method according to claim 10,
wherein in said aberration measuring step said residual aberration remaining in said image-forming optical system is measured based on image information of a mark on said surface of the specimen obtained by way of said image-forming optical system.

13. A method of manufacturing an observation apparatus for observing an image of a surface of a specimen formed by way of an image-forming optical system, said method including:

an aberration measuring step of measuring a residual aberration remaining in said image-forming optical system; and
an installing step of installing a correction plate at a predetermined position in an optical path of said image-forming optical system so as to correct said residual aberration, said correction plate having at least one surface shaped into an aspheric form.

14. The manufacturing method according to claim 13,
wherein in said installing step a correction plate selected from a plurality of correction plates prepared beforehand is installed at said predetermined position in said optical path of said image-forming optical system.

15. The manufacturing method according to claim 14,

wherein in said installing step a first correction plate having one surface shaped into an aspheric form and a second correction plate having one surface shaped into the same aspheric form as that of said one surface of said first correction plate are disposed such that said one surface of said first correction plate and said one surface of said second correction plate oppose each other, and said residual aberration is corrected by rotating each of said first and second correction plates about an optical axis of said image-forming optical system.

**16.** The manufacturing method according to claim 14,
wherein in said aberration measuring step said residual aberration remaining in said image-forming optical system is measured by using an interferometer.

**17.** The manufacturing method according to claim 14,
wherein in said aberration measuring step said residual aberration remaining in said image-forming optical system is measured based on image information of a mark on said surface of the specimen obtained by way of said image-forming optical system.

**18.** The manufacturing method according to claim 13,
wherein in said installing step a first correction plate having one surface shaped into an aspheric form and a second correction plate having one surface shaped into the same aspheric form as that of said one surface of said first correction plate are disposed such that said one surface of said first correction plate and said one surface of said second correction plate oppose each other, and said residual aberration is corrected by rotating each of said first and second correction plates about an optical axis of said image-forming optical system.

**19.** The manufacturing method according to claim 18,
wherein in said aberration measuring step said residual aberration remaining in said image-forming optical system is measured by using an interferometer.

**20.** The manufacturing method according to claim 18,
wherein in said aberration measuring step said residual aberration remaining in said image-forming optical system is measured based on image information of a mark on said surface of the specimen obtained by way of said image-forming optical system.

**21.** The manufacturing method according to claim 13,
wherein in said aberration measuring step said residual aberration remaining in said image-forming optical system is measured by using an interferometer.

**22.** The manufacturing method according to claim 13,
wherein in said aberration measuring step said residual aberration remaining in said image-forming optical system is measured based on image information of a mark on said surface of the specimen obtained by way of said image-forming optical system.

**23.** A method of manufacturing an observation apparatus for observing an image of a surface of a specimen formed by way of an image-forming optical system, saidmethod including:

an aberration measuring step of measuring a residual aberration remaining in said image-forming optical system;
a calculating step of calculating, according to a result of measurement obtained by said aberration measuring step, a surface form of a correction plate to be disposed at a predetermined position in an optical path of said image-forming optical system so as to correct said residual aberration;
a processing step of processing at least one surface of said correction plate according to a result of calculation obtained by said calculating step; and
an installing step of installing at said predetermined position in said optical path of said image-forming optical system said correction plate processed by said processing step.

**24.** The manufacturing method according to claim 23,
wherein in said aberration measuring step a measurement member having the same optical characteristic as that of said correction plate before processing is disposed at said predetermined position in said optical path of said image-forming optical system, and then said residual aberration remaining in said image-forming optical system is measured.

**25.** The manufacturing method according to claim 24,
wherein in said aberration measuring step said residual aberration remaining in said image-forming optical system is measured by using an interferometer.

**26.** The manufacturingmethod according to claim 24,
wherein in said aberration measuring step said residual aberration remaining in said image-forming optical system is measured based on image information of a mark on said surface of the specimen obtained by way of said image-forming optical system.

**27.** The manufacturing method according to claim 23,
wherein in said aberration measuring step a said correction plate before processing is disposed at said predetermined position in said optical path of said image-forming optical system, and then said residual aberration remaining in said image-forming optical system is measured.

**28.** The manufacturing method according to claim 27,
wherein in said aberration measuring step said residual aberration remaining in said image-forming optical system is measured by using an interferometer.

**29.** The manufacturing method according to claim 27,
wherein in said aberration measuring step said residual aberration remaining in said image-forming optical system is measured based on image information of a mark on said surface of the specimen obtained by way of said image-forming optical system.

**30.** The manufacturing method according to claim 23,
wherein in said aberration measuring step said residual aberration remaining in said image-forming optical system is measured by using an interferometer.

**31.** The manufacturing method according to claim 23,
wherein in said aberration measuring step said residual aberration remaining in said image-forming optical system is measured based on image information of a mark on said surface of the specimen obtained by way of said image-forming optical system.

**32.** A method of manufacturing an observation apparatus for observing an image of a surface of a specimen formed byway of an image-forming optical system, said method including:

an aberration measuring step of measuring a residual aberration remaining in said image-forming optical system; and
a correcting step of correcting said residual aberration by processing at least one of a plurality of optical surfaces constituting said image-forming optical system into an aspheric form.

**33.** A method of manufacturing an observation apparatus for observing an image of a surface of a specimen formedbywayof an image-forming optical system, said method including:

a surface form measuring step of measuring a surface form of an optical surface of each optical member constituting said image-forming optical system;
an optical characteristic measuring step of measuring an optical characteristic distribution of each optical member constituting said image-forming optical system;
an aberration measuring step of measuring a residual aberration remaining in said image-forming optical system by using an interferometer;
a chromatic aberration estimating step of estimating a chromatic aberration occurring in said image-forming optical system according to a result of measurement obtained by said surface form measuring step, a result of measurement obtained by said optical characteristic measuring step, and a result of measurement obtainedby said aberrationmeasuring step; and
an adjusting step of adjusting said image-forming optical system so as to correct said chromatic aberration estimated by said chromatic aberration estimating step.

**34.** The manufacturing method according to claim 33,
wherein in said surface formmeasuring step a curvature of an optical surface of each optical member and a center thickness of each optical member are measured.

35. The manufacturing method according to claim 34,
    wherein in said optical characteristic measuring step a refractive index distribution of each optical member is measured.

36. The manufacturing method according to claim 33,
    wherein in said optical characteristic measuring step a refractive index distribution of each optical member is measured.

37. A method of manufacturing an observation apparatus for observing an image of a surface of a specimen formed by way of an image-forming optical system, saidmethod including:

    a surface form measuring step of measuring surface forms of optical surfaces of numbers of optical members made so as to constitute said image-forming optical system;
    an optical characteristic measuring step of measuring an optical characteristic distribution of numbers of optical members made so as to constitute said image-forming optical system;
    an aberration estimating step of estimating, according to a result of measurement obtained by said surface form measuring step and a result of measurement obtained by said optical characteristic measuring step, an aberration occurring in an image-forming optical system obtained by combining said optical members; and
    an assembling step of assembling an image-forming optical system by combining optical members selected according to a result of estimation obtained by said aberration estimating step.

38. The manufacturing method according to claim 37,
    wherein in said surface formmeasuring step a curvature of an optical surface of each optical member and a center thickness of each optical member are measured.

39. The manufacturing method according to claim 38,
    wherein in said optical characteristic measuring step a refractive index distribution of each optical member is measured.

40. The manufacturing method according to claim 37,
    wherein in said optical characteristic measuring step a refractive index distribution of each optical member is measured.

41. An exposure apparatus for exposing a pattern on a mask onto a photosensitive substrate, said exposure apparatus comprising:

    an illumination system for illuminating a mask;
    a projection optical system for forming a pattern image of said mask onto a photosensitive substrate; and
    the observation apparatus according to one of claims 1 to 9 for observing said mask or said photosensitive substrate as the surface of a specimen.

42. An exposure method for exposing a pattern of a mask to a photosensitive substrate,
    wherein the exposure apparatus according to claim 41 is used for forming said pattern image of said illuminated mask onto a photosensitive substrate.

43. A method of manufacturing a microdevice, said method including an exposure step of exposing a pattern of said mask to said photosensitive substrate by using the exposure apparatus according to claim 41, and a developing step of developing said photosensitive substrate exposed by said exposure step.

44. An exposure apparatus for exposing a pattern on a mask to a photosensitive substrate, said exposure apparatus comprising:

    an illumination system for illuminating a mask;
    a projection optical system for forming a pattern image of said mask onto a photosensitive substrate; and
    an observation apparatus for observing said mask or said photosensitive substrate as the surface of a specimen;

wherein said observation apparatus is made by the manufacturing method according to one of claims 10 to 40.

**45.** An exposure method for exposing a pattern of a mask to a photosensitive substrate,
wherein the exposure apparatus according to claim 44 is used for forming said pattern image of said illuminated mask onto a photosensitive substrate.

**46.** A method of manufacturing a microdevice including an exposure step of exposing a pattern of said mask to said photosensitive substrate by using the exposure apparatus according to claim 44, and a developing step of developing said photosensitive substrate exposed by said exposure step.

# Fig.1

# *Fig.2*

# Fig.3

```
┌─────────────────────────────────────┐
│   MEASURE ABERRATION REMAINING       │───── S11
│   IN IMAGE-FORMING OPTICAL SYSTEM    │
└─────────────────────────────────────┘
                    │
                    ▼
┌─────────────────────────────────────┐
│ INSTALL A PAIR OF ABERRATION CORRECTION │───── S12
│    PLATES IN PARALLEL OPTICAL PATH   │
└─────────────────────────────────────┘
                    │
                    ▼
┌─────────────────────────────────┐
│   CORRECT RESIDUAL ABERRATION    │───── S13
│      BY ROTATING A PAIR OF       │
│        ABERRATION PLATES         │
└─────────────────────────────────┘
                    │
                    ▼
┌─────────────────────────────────┐
│ VERIFY IF RESIDUAL ABERRATION OF │───── S14
│  IMAGE-FORMING OPTICAL SYSTEM    │
│      IS FAVORABLY CORRECTED      │
└─────────────────────────────────┘
```

# Fig.4

2ND IMAGE-FORMING
OPTICAL SYSTEM

1ST IMAGE-FORMING
OPTICAL SYSTEM

# Fig.5

*Fig.6*

*Fig.7*

**Fig.8**

**Fig.9**

**Fig.10**

**Fig.11**

**Fig.12**

**Fig.13**

## Fig.14

1ST IMAGE-FORMING
OPTICAL SYSTEM

# Fig.15

```
┌─────────────────────────────────┐
│  MEASURE ABERRATION REMAINING   │ ── S21
│  IN IMAGE-FORMING OPTICAL SYSTEM │
└─────────────────────────────────┘
                 │
                 ▼
┌─────────────────────────────────┐
│   CALCULATE SURFACE FORM OF      │
│ PROCESSED SURFACE TO BE GIVEN    │ ── S22
│ TO ABERRATION CORRECTION PLATE   │
└─────────────────────────────────┘
                 │
                 ▼
┌─────────────────────────────────┐
│      POLISH ONE SURFACE OF       │
│ ABERRATION CORRECTION PLATE TO   │ ── S23
│   DETERMINED SURFACE FORM        │
└─────────────────────────────────┘
                 │
                 ▼
┌─────────────────────────────────┐
│   INSPECT PROCESSED SURFACE      │
│     OF POLISHED ABERRATION       │ ── S24
│       CORRECTION PLATE           │
└─────────────────────────────────┘
                 │
                 ▼
┌─────────────────────────────────┐
│   INSTALL POLISHED ABERRATION    │
│       CORRECTION PLATE           │ ── S25
│         IN OPTICAL PATH          │
└─────────────────────────────────┘
                 │
                 ▼
┌─────────────────────────────────┐
│  VERIFY IF RESIDUAL ABERRATION   │
│     TO BE CORRECTED IS           │ ── S26
│     CORRECTED FAVORABLY          │
└─────────────────────────────────┘
```

## Fig.16

```
                        ( START )
                            │
                            ▼
        ┌─────────────────────────────────┐
        │  DEPOSIT METAL FILM ON WAFER     │────── STEP 301
        └─────────────────────────────────┘
                            │
                            ▼
        ┌─────────────────────────────────┐
        │  APPLY PHOTORESIST ONTO METAL FILM │
        └─────────────────────────────────┘
                                        STEP 302
                            │
                            ▼
        ┌─────────────────────────────────────────────┐
        │    TRANSFER PATTERN IMAGE ON RETICLE         │
        │     ONTO EACH SHOT AREA ON WAFER             │
        │  BY USING EXPOSURE APPARATUS OF EMBODIMENT   │
        └─────────────────────────────────────────────┘
                                            STEP 303
                            │
                            ▼
        ┌─────────────────────────────────┐
        │   DEVELOP PHOTORESIST ON WAFER   │
        └─────────────────────────────────┘
                                        STEP 304
                            │
                            ▼
        ┌─────────────────────────────────┐
        │        ETCH WAFER                │────── STEP 305
        │  USING RESIST PATTERN AS MASK    │
        └─────────────────────────────────┘
                            │
                            ▼
                      ( NEXT STEP )
```

## Fig.17

```
            ┌─────────────┐
            │    START    │
            └──────┬──────┘
                   │
                   ▼
         ┌───────────────────┐
         │ PATTERN FORMING   │────── STEP 401
         │       STEP        │
         └─────────┬─────────┘
                   │
                   ▼
         ┌───────────────────┐
         │ COLOR FILTER      │────── STEP 402
         │ FORMING STEP      │
         └─────────┬─────────┘
                   │
                   ▼
         ┌───────────────────┐
         │ CELL ASSEMBLING   │────── STEP 403
         │       STEP        │
         └─────────┬─────────┘
                   │
                   ▼
         ┌───────────────────┐
         │ MODULE ASSEMBLING │────── STEP 404
         │       STEP        │
         └─────────┬─────────┘
                   │
                   ▼
            ┌─────────────┐
            │     END     │
            └─────────────┘
```

**EP 1 349 201 A1**

| INTERNATIONAL SEARCH REPORT | International application No. |
|---|---|
| | PCT/JP01/10257 |

**A. CLASSIFICATION OF SUBJECT MATTER**

Int.Cl$^7$  H01L21/027, G03F7/20, G01B11/24, G01M11/00, G02B7/02, G02B13/24

According to International Patent Classification (IPC) or to both national classification and IPC

**B. FIELDS SEARCHED**

Minimum documentation searched (classification system followed by classification symbols)

Int.Cl$^7$  H01L21/027, G03F7/20, G01B11/24, G01M11/00, G02B7/02, G02B13/24

Documentation searched other than minimum documentation to the extent that such documents are included in the fields searched
| Jitsuyo Shinan Koho | 1926-1996 | Toroku Jitsuyo Shinan Koho | 1994-2002 |
| Kokai Jitsuyo Shinan Koho | 1971-2002 | Jitsuyo Shinan Toroku Koho | 1996-2002 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 7-151963 A (Sony Corporation), | 1-9,41-43 |
| Y | 16 June, 1995 (16.06.1995), | 10-22,44-46 |
| Y | Par. Nos. [0010], [0015] to [0020]; Fig. 2 | 23-32 |
| | (Family: none) | |
| | | |
| | JP 2000-235725 A (Pioneer Electronic Corporation), | |
| | 29 August, 2000 (29.08.2000), | |
| X | Par. Nos. [0022] to [0027], [0044]; Figs. 2, 5 | 1-9,41-43 |
| | & US 6320699 B1 | |
| | | |
| | JP 2000-214047 A (Nikon Corporation), | |
| | 04 August, 2000 (04.08.2000), | |
| Y | abstract | 10-22,44-46 |
| Y | (Family: none) | 23-32 |
| | | |
| | JP 5-296879 A (Olympus Optical Company, Limited), | |
| | 12 November, 1993 (12.11.1993), | |
| Y | abstract | 11,16,19,21 |
| Y | (Family: none) | 25,28,30 |

☒ Further documents are listed in the continuation of Box C. ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 12 February, 2002 (12.02.02) | 19 February, 2002 (19.02.02) |

| Name and mailing address of the ISA/ | Authorized officer |
|---|---|
| Japanese Patent Office | |
| Facsimile No. | Telephone No. |

Form PCT/ISA/210 (second sheet) (July 1992)

## INTERNATIONAL SEARCH REPORT

| | International application No. |
|---|---|
| | PCT/JP01/10257 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2000-21752 A (Canon Inc.),<br>21 January, 2000 (21.01.2000),<br>Par. Nos. [0070] to [0075]; Fig. 9<br>& US 6172740 B1 | 10-22,44-46 |
| A | JP 11-125512 A (Nikon Corporation),<br>11 May, 1999 (11.05.1999),<br>abstract<br>(Family: none) | 23-32 |
| X | JP 63-19612 A (Matsushita Electric Ind. Co., Ltd.),<br>27 January, 1988 (27.01.1988),<br>working example<br>(Family: none) | 33-40 |

Form PCT/ISA/210 (continuation of second sheet) (July 1992)